# EUROPÄISCHE PATENTANMELDUNG

(11) **EP 0 945 901 A1**
(43) Veröffentlichungstag der Anmeldung: **29.09.1999**
(21) Anmeldenummer: 99100646.1
(22) Anmeldetag: 14.01.1999
(51) Int. Cl.: H01L 27/108, H01L 21/8242

(54) **DRAM-Zellenanordnung mit vertikalen Transistoren und Verfahren zu deren Herstellung**

(30) Priorität: 23.03.1998 DE 19812642
(71) Anmelder: SIEMENS AKTIENGESELLSCHAFT, 80333 München (DE)
(72) Erfinder: Göbel, Bernd, 81735 München (DE); Hofmann, Franz, Dr., 80995 München (DE); Martin, Eve Marie, 80939 München (DE); Rösner, Wolfgang, Dr., 81739 München (DE); Bertagnolli, Emmerich, 80799 München (DE)

(57) **Zusammenfassung**

Eine Speicherzelle umfaßt einen Vorsprung (V) von in Reihen und Spalten angeordneten Vorsprüngen (V) eines Halbleitersubstrats (1), wobei zueinander benachbarte Reihen der Vorsprünge (V) bezüglich einer parallel zu den Spalten verlaufenden y-Achse zueinander translationssymmetrisch sind. Der Vorsprung (V) umfaßt mindestens ein erstes Source/Drain-Gebiet (S/D1) eines Auswahltransistors und ein darunter angeordnetes Kanalgebiet (Ka), das ringförmig von einer Gateelektrode (Ga) umgeben wird. Ein Speicherkondensator ist zwischen dem ersten Source/Drain-Gebiet (S/D1) und einer Bitleitung (B) geschaltet. Sowohl die Bitleitung (B) als auch der Speicherkondensator sind im wesentlichen oberhalb des Halbleitersubstrats (1) angeordnet. Zweite Source/Drain-Gebiete (S/D2) von Auswahltransistoren sind im Halbleitersubstrat (1) vergraben und miteinander verbunden. Wortleitungen können selbstjustiert in Form von aneinander angrenzenden Gateelektroden (Ga) gebildet werden. Die Vorsprünge (V) können durch Ätzen mit nur einer Maske erzeugt werden. Die Speicherzelle ist mit einer Fläche von 4F² herstellbar, wobei F die minimale, in der jeweiligen Technologie herstellbare Strukturgröße ist.

## Beschreibung

Die Erfindung betrifft eine DRAM-Zellenanordnung sowie ein Verfahren zu deren Herstellung.

In DRAM-Zellenanordnungen, d.h. Speicherzellen-Anordnungen mit dynamischem, wahlfreiem Zugriff, werden fast ausschließlich sog. Eintransistor-Speicherzellen eingesetzt. Eine Eintransistor-Speicherzelle umfaßt einen Auswahltransistor und einen Speicherkondensator. In dem Speicherkondensator ist die Information in Form einer elektrischen Ladung gespeichert, die eine logische Größe, 0 oder 1, darstellt. Durch AnSteuerung des Auswahltransistors über eine Wortleitung kann diese Information über eine Bitleitung ausgelesen werden.

In der Regel werden ein erstes Source/Drain-Gebiet des Auswahltransistors mit dem Speicherkondensator und ein zweites Source/Drain-Gebiet des Auswahltransistors mit der Bitleitung verbunden. Eine Gateelektrode des Auswahltransistors ist mit der Wortleitung verbunden (vgl. z.B. S.M.Sze Semiconductor Devices, AT&T Bell Laboratories, Murray Hill, New Jersey 1985, Seite 487, Figur 18a).

Da von Speichergeneration zu Speichergeneration die Speicherdichte zunimmt, muß die Fläche der Eintransistor-Speicherzelle von Generation zu Generation reduziert werden. Da einer bloßen Reduktion von Abmessungen der Speicherzelle durch die minimale, in der jeweiligen Technologie herstellbare Strukturgröße F Grenzen gesetzt sind, ist dies auch mit einer Veränderung der Speicherzelle verbunden. So wurden bis zur 1MBit-Generation sowohl der Auswahltransistor als auch der Speicherkondensator als planare Bauelemente realisiert. Ab der 4MBit-Speichergeneration mußte eine weitere Flächenreduzierung durch eine dreidimensionale Anordnung von Auswahltransistor und Speicherkondensator erfolgen.

Eine Möglichkeit besteht darin, den Speicherkondensator nicht planar, sondern in einem Graben zu realisieren (siehe z.B. K. Yamada et al. 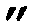 A deep trenched Capacitor technology for 4 MBit DRAMs", Proc. Intern. Electronic Devices and Materials IEDM 85, Seite 702).

Die Erzeugung eines solchen vergrabenen Speicherkondensators ist jedoch aufwendig. Auch können Kondensatordielektrika mit hohen Dielektrizitätskonstanten nicht verwendet werden, da ihre Abscheidung nur auf im wesentlichen planaren Flächen möglich ist.

In der deutschen Patentschrift 195 19 160 C1 ist eine DRAM-Zellenanordnung vorgeschlagen worden, bei der der Speicherkondensator über dem Auswahltransistor erzeugt wird, und die Bitleitung im Substrat vergraben ist. Da der Speicherkondensator an einer Oberfläche des Substrats erzeugt wird, können Kondensatordielektrika mit hohen Dielektrizitätskonstanten verwendet werden. Jede Speicherzelle umfaßt eine vorsprungsartige Halbleiterstruktur, die ein erstes Source/Drain-Gebiet, ein darunter angeordnetes Kanalgebiet und ein darunter angeordnetes zweites Source/Drain-Gebiet umfaßt und die von einer Gateelektrode ringförmig umgeben wird. Halbleiterstrukturen von Speicherzellen sind in Reihen und Spalten angeordnet, wobei benachbarte Reihen der Halbleiterstrukturen bezüglich einer parallel zu den Spalten verlaufenden Achse zueinander translationssymmetrisch sind. Um Wortleitungen selbstjustiert, d.h. ohne Verwendung von zu justierenden Masken zu erzeugen, sind Abstände zwischen entlang den Spalten angeordneten Halbleiterstrukturen kleiner als Abstände zwischen entlang den Reihen angeordneten Halbleiterstrukturen. Die Halbleiterstrukturen werden von einer gitterförmigen Vertiefung umgeben. Die Wortleitungen entstehen durch Abscheiden und Rückätzen von leitendem Material in Form von entlang der Spalten aneinander angrenzenden Gateelektroden. Die vergrabene Bitleitung wird aus einer dotierten Schicht erzeugt, die durch mit isolierendem Material gefüllte Gräben streifenförmig strukturiert wird. Die Gräben werden mit Hilfe einer streifenförmigen ersten Maske erzeugt. Mit Hilfe einer streifenförmigen zweiten Maske, deren Streifen senkrecht zu den Gräben verlaufen, werden durch Ätzen von Halbleitermaterial zwischen den Gräben Vertiefungen erzeugt, die, um die Bitleitung nicht zu durchtrennen, die dotierte Schicht nicht durchtrennen. Die Halbleiterstrukturen entstehen aus einer Schichtenfolge durch die Erzeugung der Gräben und der Vertiefungen. Die Vertiefungen werden ebenfalls mit isolierendem Material gefüllt. Anschließend wird das isolierende Material rückgeätzt, wodurch die Halbleiterstrukturen freigelegt werden und die gitterförmige Vertiefung entsteht. Aufgrund des gemeinsamen Ätzens des isolierenden Materials in den Vertiefungen und des isolierenden Materials in den Gräben, ist der Boden der gitterförmigen Vertiefung eben, was für die selbstjustierte Erzeugung der Wortleitungen wesentlich ist. Zur Erhöhung der Packungsdichte wird die erste Maske erzeugt, indem zunächst durch ein photolithographisches Verfahren Streifen der Breite F erzeugt werden, die durch Abscheiden und Rückätzen von Material verbreitert werden. Auf diese Weise beträgt ein Abstand zwischen zueinander benachbarten Streifen der ersten Maske weniger als F. Die Streifen der zweiten Maske werden mit der Breite F erzeugt, weshalb die obengenannten Bedingungen der Abstände zwischen den Halbleiterstrukturen erfüllt werden. Die Speicherzellenfläche beträgt 4F². Das erste Source/Drain-Gebiet wirkt als erste Kondensatorelektrode des Speicherkondensators. Eine zweite Kondensatorelektrode wird durch ganzflächiges Abscheiden von leitendem Material über dem Kondensatordielektrikum erzeugt.

In US 4 630 088 ist vorgeschlagen worden, den Speicherkondensator zwischen einem ersten Source/Drain-Gebiet des Auswahltransistors und der Bitleitung zu schalten. Jede Speicherzelle umfaßt eine vorsprungsartige Halbleiterstruktur, die von einer Gateelektrode ringförmig umgeben wird. Die Speicherzellen sind bezüglich einer Wortleitungsrichtung diagonal versetzt zueinander angeordnet. Der Speicherkondensator umfaßt das erste Source/Drain-Gebiet, einen Teil eines ganzflächig abgeschiedenen Kondensatordielektrikums und einen Teil der Bitleitung. Das erste Source/Drain-Gebiet, ein Kanalgebiet und ein zweites Source/Drain-Gebiet des Auswahltransistors sind schichtartig übereinander angeordnet.

Der Erfindung liegt das Problem zugrunde, eine DRAM-Zellenanordnung anzugeben, die bei hoher Packungsdichte mit im Vergleich zum Stand der Technik kleinerem Prozeßaufwand herstellbar ist. Ferner soll ein Herstellungsverfahren für eine solche DRAM-Zellenanordnung angegeben werden.

Dieses Problem wird gelöst durch eine DRAM-Zellenanordnung gemäß Anspruch 1 sowie ein Verfahren zu deren Herstellung gemäß Anspruch 6. Weitere Ausgestaltungen der Erfindung gehen aus den übrigen Ansprüchen hervor.

Bei einer erfindungsgemäßen DRAM-Zellenanordnung weist ein Halbleitersübstrat in Reihen und Spalten angeordnete Vorsprünge auf. Zueinander benachbarte Reihen der Vorsprünge sind bezüglich einer parallel zu den Spalten verlaufenden Achse zueinander translationssymmetrisch. Jeder Vorsprung umfaßt mindestens ein erstes Source/Drain-Gebiet und ein darunter angeordnetes Kanalgebiet eines vertikalen Auswahltransistors. Der Vorsprung kann auch ein zweites Source/Drain-Gebiet des Auswahltransistors umfassen. Mindestens im Bereich des Kanalgebiets ist der Vorsprung mit einem Gatedielektrikum versehen. Der Vorsprung wird von einer Gateelektrode des Auswahltransistors ringförmig umgeben. Eine Wortleitung wird durch entlang einer Reihe zueinander benachbarte und aneinander angrenzende Gateelektroden gebildet. Das erste Source/Drain-Gebiet ist mit einer ersten Kondensatorelektrode eines Speicherkondensators elektrisch verbunden. Die erste Kondensatorelektrode ist durch ein Kondensatordielektrikum von einer über der ersten Kondensatorelektrode angeordneten zweiten Kondensatorelektrode des Speicherkondensators getrennt. Die zweite Kondensatorelektrode ist mit einer im wesentlichen parallel zu den Spalten verlaufenden Bitleitung elektrisch verbunden. Der Speicherkondensator ist also zwischen dem ersten Source/Drain-Gebiet und der Bitleitung geschaltet. Das zweite Source/Drain-Gebiet ist im Halbleitersubstrat vergraben.

Um die zweiten Source/Drain-Gebiete von Auswahltransistoren an ein gemeinsames Potential anzuschließen, ist es vorteilhaft, mindestens einige von ihnen miteinander zu verbinden.

Da die zweiten Source/Drain-Gebiete nicht mit Bitleitungen verbunden sind, können sie Teile einer durchgehenden Schicht sein, die nicht strukturiert werden muß. Für die Erzeugung der zweiten Source/Drain-Gebiete ist eine Maske nicht erforderlich, was den Prozeßaufwand verkleinert.

Da sowohl die Bitleitung als auch der Speicherkondensator an einer Oberfläche des Halbleitersubstrats erzeugt werden, wird die Erzeugung von im Halbleitersubstrat vergrabenen Strukturen vermieden, was ebenfalls den Prozeßaufwand verkleinert.

Die Verwendung von Kondensatordielektrika mit hohen Dielektrizitätskonstanten ist möglich, da der Speicherkondensator nicht in einem tiefen Graben erzeugt wird.

Ein Vorteil der erfindungsgemäßen Speicherzellenanordnung ist, daß α-Teilchen, die im Halbleitersubstrat entstehen, die an der Oberfläche des Halbleitersubstrats angeordnete Bitleitung und den Speicherkondensator mit nur geringer Wahrscheinlichkeit erreichen und daß deshalb die Wahrscheinlichkeit einer Verfälschung von Informationen gering ist.

Die Vorsprünge werden vorzugsweise durch Strukturierung einer Schichtenfolge erzeugt. Dazu werden eine von einem ersten Leitfähigkeitstyp dotierte erste Schicht, darüber eine von einem zweiten, zum ersten Leitfähigkeitstyp entgegengesetzten Leitfähigkeitstyp dotierte zweite Schicht und darüber eine vom ersten Leitfähigkeitstyp dotierte dritte Schicht erzeugt. Die erste Schicht, die zweite Schicht und die dritte Schicht können durch Implantation des Halbleitersubstrats und/oder durch in situ dotierte Epitaxie erzeugt werden. Wird eine Schicht durch in situ dotierte Epitaxie erzeugt, so wird das Halbleitersubstrat um diese Schicht erweitert.

Zur Prozeßvereinfachung ist es vorteilhaft, wenn die Vorsprünge durch Ätzen mit nur einer Maske erzeugt werden. Dabei wird eine gitterförmige Vertiefung erzeugt, die mindestens die dritte Schicht und die zweite Schicht durchtrennen. Sämtliche vertikale, d.h. zur Oberfläche des Halbleitersubstrats senkrechte Abmessungen jedes Vorsprungs sind also gleich. In anderen Worten: alle Flanken jedes Vorsprungs weisen dieselbe zur Oberfläche des Halbleitersubstrats senkrechte Länge auf. Alternativ können in einem ersten Ätzschritt parallel zueinander verlaufende erste Gräben erzeugt werden und in einem zweiten Prozeßschritt quer zu den ersten Gräben verlaufende zweite Gräben erzeugt werden.

Aus der dritten Schicht entstehen als Teile der Vorsprünge erste Source/Drain-Gebiete der Auswahltransistoren und aus der zweiten Schicht Kanalgebiete der Auswahltransistoren. Die gitterförmige Vertiefung, bzw. die ersten Gräben und die zweiten Gräben können bis in die erste Schicht reichen. Die zweiten Source/Drain-Gebiete sind Teile der ersten Schicht.

Zur Prozeßvereinfachung ist es vorteilhaft, die gitterförmige Vertiefung, bzw. die ersten Gräben und die zweiten Gräben möglichst flach herzustellen, indem die erste Schicht nicht durchtrennt wird.

Zur Prozeßvereinfachung ist es vorteilhaft, wenn die Wortleitungen selbstjustiert erzeugt werden. Die selbstjustierte Erzeugung ist zum Beispiel möglich, wenn zu Spalten-Richtung parallele Abstände zwischen entlang den Spalten angeordneten Vorsprüngen größer sind als zu Reihen-Richtung parallele Abstände zwischen entlang den Reihen angeordneten Vorsprüngen. Zur Erzeugung der Wortleitungen wird leitendes Material konform abgeschieden, wobei eine wellenförmige leitende Schicht entsteht. Täler der Wellen der leitenden Schicht verlaufen parallel zu den Reihen. Das leitende Material füllt den Raum zwischen den entlang den Reihen angeordneten Vorsprüngen aus, während es den Raum zwischen den entlang den Spalten angeordneten Vorsprüngen nicht auffüllt. Die leitende Schicht wird anisotrop rückgeätzt, bis Teile der leitenden Schicht, die oberhalb der ersten Source-/Drain-Gebiete und zwischen den entlang den Spalten benachbarten Vorsprüngen angeordnet sind, entfernt werden. Dabei entstehen aus der leitenden Schicht die Wortleitungen, die in Spalten-Richtung nicht miteinander verbunden sind. Da das leitende Material den Raum zwischen den entlang den Reihen angeordneten Vorsprüngen auffüllt, ist auch nach Rückätzung des leitenden Materials zusammenhängendes leitendes Material zwischen den entlang den Reihen angeordneten Vorsprüngen vorhanden. An zur Richtung der Reihen parallele Flanken der Vorsprünge sind die Wortleitungen bzw. die Gateelektroden spacerförmig.

Zur Erhöhung der Packungsdichte ist es vorteilhaft, wenn die Abstände zwischen den entlang den Reihen angeordneten Vorsprüngen kleiner als F betragen. Zur Erzeugung der Vorsprünge kann eine Maske verwendet werden, die in Reihen-Richtung durch Spacer verbreitert wurde. Beispielsweise werden erste Teile der Maske erzeugt, indem Material abgeschieden und durch eine streifenförmige erste Photolackmaske strukturiert wird, deren Streifen parallel zu den Spalten verlaufen. Anschließend wird weiteres Material abgeschieden und rückgeätzt, wodurch an Flanken der ersten Teile der Maske spacerförmige zweite Teile der Maske entstehen. Mit Hilfe einer streifenförmigen zweiten Photolackmaske, deren Streifen parallel zu den Reihen verlaufen, werden die ersten Teile und die zweiten Teile der Maske strukturiert, wodurch die Maske entsteht. Die Breiten der Streifen der ersten Photolackmaske und der zweiten Photolackmaske sowie die Abstände zwischen den Streifen der ersten Photolackmaske und die Abstände zwischen den Streifen der zweiten Photolackmaske betragen vorzugsweise F. Durch die beschriebenen Prozeßschritte wird gewährleistet, daß die Abstände zwischen den entlang den Reihen angeordneten Vorsprüngen kleiner sind als die Abstände zwischen den entlang den Spalten angeordneten Vorsprüngen.

Zur Prozeßvereinfachung ist es vorteilhaft, wenn das erste Source/Drain-Gebiet mit der ersten Kondensatorelektrode übereinstimmt. Alternativ wird über dem ersten Source/Drain-Gebiet die erste Kondensatorelektrode zum Beispiel durch Strukturierung einer weiteren leitenden Schicht erzeugt.

Zur Prozeßvereinfachung ist es vorteilhaft, wenn die zweite Kondensatorelektrode ein Teil der Bitleitung ist. Dazu kann über dem Kondensatordielektrikum leitendes Material abgeschieden und streifenförmig strukturiert werden.

Zur Vergrößerung des Signals des Speicherkondensators ist es vorteilhaft, wenn das Kondensatordielektrikum aus einem Material mit einer hohen Dielektrizitätskonstanten, wie zum Beispiel Perovskite (z.B. Ba_{X}Sr_{1-X}TiO₃, SrBi₂Ta₂O₃, PbZrTiO₃) oder Ta₂O₅, erzeugt wird. Da solche Materialien vorzugsweise auf ebenen Flächen abgeschieden werden, ist es vorteilhaft, nach Erzeugung der Gateelektroden eine isolierende Struktur zu erzeugen, indem isolierendes Material abgeschieden und planarisiert wird, bis die ersten Source/Drain-Gebiete freigelegt werden. Über den ersten Source/Drain-Gebieten, die als erste Kondensatorelektroden wirken, wird dann das Kondensatordielektrikum abgeschieden.

Das Halbleitersubstrat ist z.B. ein Siliziumsubstrat oder ein SOI-Substrat.

Im folgenden wird ein Ausführungsbeispiel der Erfindung, das in den Figuren dargestellt ist, näher erläutert.
- Figur 1a: zeigt einen Querschnitt durch ein Substrat, nachdem eine erste Schicht, eine zweite Schicht, eine dritte Schicht, erste Teile einer Maske und zweite Teile der Maske erzeugt wurden.
- Figur 1b: zeigt einen zum Querschnitt aus Figur 1a senkrechten Querschnitt durch das Substrat nach den Prozeßschritten aus Figur 1a.
- Figur 2a: zeigt den Querschnitt aus Figur 1a, nachdem Vorsprünge, erste Source/Drain-Gebiete, Kanalgebiete, zweite Source/Drain-Gebiete, ein Gatedielektrikum, Gateelektroden und Wortleitungen erzeugt wurden.
- Figur 2b: zeigt den Querschnitt aus Figur 1b nach den Prozeßschritten aus Figur 2a.
- Figur 3a: zeigt den Querschnitt aus Figur 2a, nachdem eine isolierende Struktur, ein Kondensatordielektrikum und Bitleitungen erzeugt wurden.
- Figur 3b: zeigt den Querschnitt aus Figur 2b nach den Prozeßschritten aus Figur 3a.
- Figur 4: zeigt eine Aufsicht auf das Substrat, in der die Lage einer ersten Photolackmaske und einer zweiten Photolackmaske dargestellt sind.

Die Figuren sind nicht maßstabsgerecht.

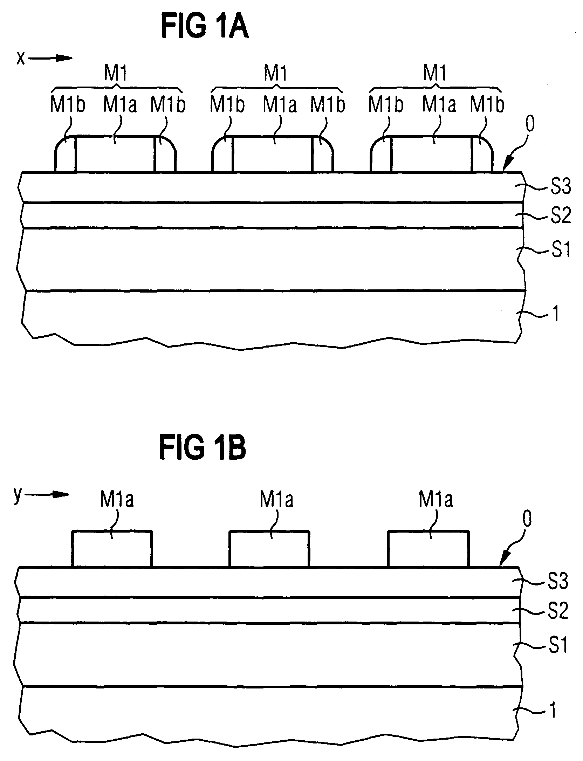

Ausgangsmaterial ist ein Substrat 1 aus Silizium, das p-dotiert ist und eine Dotierstoffkonzentration von ca. 10¹⁷cm⁻³ aufweist. Durch in situ dotierte Epitaxie wird eine ca. 500 nm dicke n-dotierte erste Schicht S1 erzeugt. Die Dotierstoffkonzentration der ersten Schicht S1 beträgt ca. 10²⁰cm⁻³. Durch in situ dotierte Epitaxie wird eine ca. 200nm dicke p-dotierte zweite Schicht S2 erzeugt. Die Dotierstoffkonzentration der zweiten Schicht S2 beträgt ca. 3*10¹⁷ cm⁻³. Durch in situ dotierte Epitaxie wird eine ca. 200nm dicke n-dotierte dritte Schicht S3 erzeugt. Die Dotierstoffkonzentration der dritten Schicht S3 beträgt ca. 10²¹ cm⁻³ (siehe Figuren 1a und 1b). Das Substrat 1 wird durch die erste Schicht S1, die zweite Schicht S2 und die dritte Schicht S3 erweitert. Entlang einer Oberfläche O des Substrats 1 verlaufen eine y-Achse y und senkrecht zur y-Achse y eine x-Achse x.

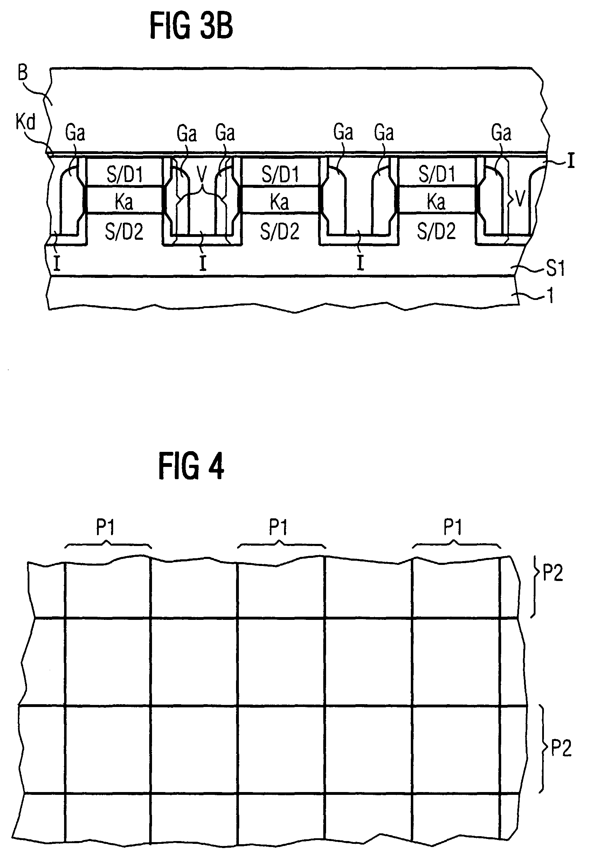

Zur Erzeugung einer Maske M1 wird in einem TEOS-Verfahren SiO₂ in einer Dicke von ca. 100nm abgeschieden. Mit Hilfe einer streifenförmigen ersten Photolackmaske P1 (siehe Figur 4), deren Streifen parallel zur y-Achse y verlaufen, eine Breite von ca. 250nm aufweisen und einen Abstand von ca. 250nm voneinander aufweisen, wird SiO₂ streifenförmig strukturiert, wodurch erste Teile M1a der Maske M1 entstehen. Nach Entfernen der ersten Photolackmaske P1 wird SiO₂ in einer Dicke von ca. 80nm abgeschieden und rückgeätzt, wodurch entlang Flanken der ersten Teile M1a der Maske M1 spacerförmige Zweite Teile M1b der Maske M1 entstehen (siehe Figuren 1a und 1b). Als Ätzmittel ist zum Beispiel CHF₃ + O₂ geeignet.

Mit Hilfe einer streifenförmigen zweiten Photolackmaske P2 (siehe Figur 4), deren Streifen parallel zur x-Achse x verlaufen, eine Breite von ca. 250nm aufweisen und einen Abstand von ca. 250nm voneinander aufweisen, wird SiO₂ geätzt, wodurch die ersten Teile M1a und die zweiten Teile M1b der Maske M1 weiter strukturiert werden. Dabei entsteht die Maske M1 (siehe Figuren 1a und 1b).

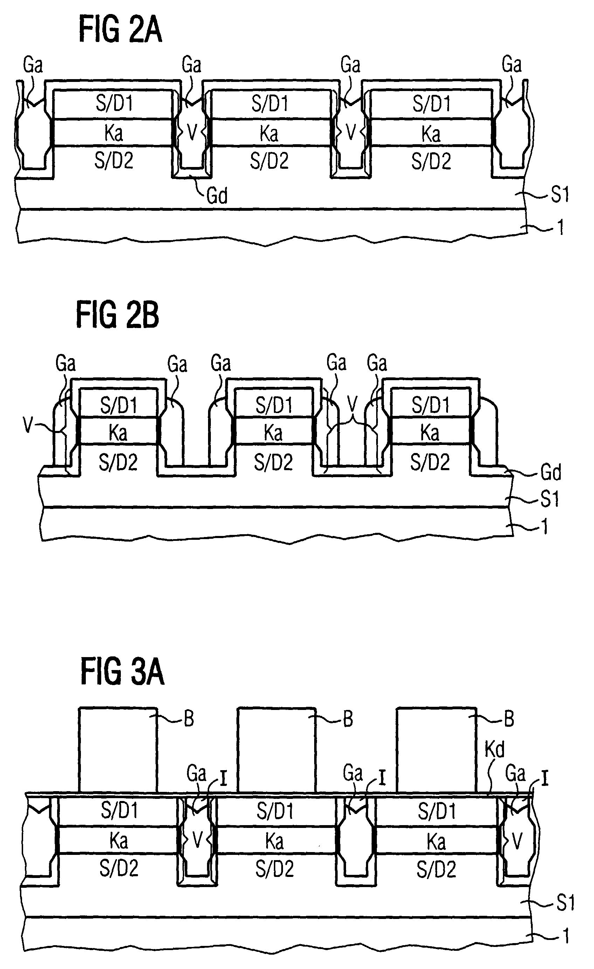

Nach Entfernen der zweiten Photolackmaske P2 wird Silizium mit z. B HBr + NF₃ + He + O₂ ca. 600nm tief geätzt, wodurch die dritte Schicht S3 und die zweite Schicht S2 durchtrennt werden. Aus dem Substrat 1 entstehen quaderförmige Vorsprünge V, deren Abstände voneinander in Richtung der x-Achse x kleiner sind als in Richtung der y-Achse y. Die Vorsprünge V sind von einer gitterförmigen Vertiefung umgeben. Als Teile der Vorsprünge V entstehen aus der dritten Schicht S3 erste Source/Drain-Gebiete S/D1 von vertikalen Auswahltransistoren und aus der zweiten Schicht S2 Kanalgebiete Ka. Teile der ersten Schicht S1, die unter den Kanalgebieten Ka angeordnet sind, wirken als zweite Source/Drain-Gebiete S/D2 (siehe Figuren 2a und 2b). Durch Ätzen mit zum Beispiel CHF₃ und O₂ wird die Maske M1 entfernt.

Zur Erzeugung eines Gatedielektrikums Gd wird durch thermische Oxidation SiO₂ in einer Dicke von ca. 5nm aufgewachsen.

Zur Erzeugung einer ersten leitenden Schicht wird in situ n-dotiertes Polysilizium in einer Dicke von ca. 80nm abgeschieden. Die erste leitende Schicht ist wellenförmig, wobei die Wellen, d.h. ihre Berge und Täler, parallel zur x-Achse x verlaufen. Die erste leitende Schicht füllt den Raum zwischen den entlang der x-Achse x angeordneten Vorsprüngen V auf, während sie den Raum zwischen den entlang der y-Achse y angeordneten Vorsprüngen V nicht auffüllt. Durch Rückätzen mit zum Beispiel C₂F₆ + O₂ wird Polysilizium ca. 150nm tief rückgeätzt, wodurch Teile des Gatedielektrikums Gd auf den ersten Source/Drain-Gebieten S/D1 und Teile des Gatedielektrikums Gd zwischen den entlang der y-Achse y angeordneten Vorsprüngen V freigelegt werden. An zur x-Achse x parallele Flanken der Vorsprünge V wird dadurch die erste leitende Schicht spacerförmig strukturiert. Aus der ersten leitenden Schicht entstehen Gateelektroden Ga, die die Vorsprünge V ringförmig umgeben. Entlang der x-Achse x benachbarte Gateelektroden Ga grenzen aneinander an und bilden Wortleitungen. Die Wortleitungen verlaufen also parallel zur x-Achse x (siehe Figuren 2a und 2b).

Zur Erzeugung einer isolierenden Struktur I wird SiO₂ in einem TEOS-Verfahren in einer Dicke von ca. 300 nm abgeschieden und durch chemisch-mechanisches Polieren planarisiert, bis die ersten Source/Drain-Gebiete S/D1 freigelegt werden (siehe Figuren 3a und 3b).

Anschließend wird ein Kondensatordielektrikum Kd erzeugt, indem Bariumstrontiumtitanat in einer Dicke von ca. 20nm ganzflächig abgeschieden wird (siehe Figuren 3a und 3b).

Durch Abscheiden von AlSiCu in einer Dicke von ca. 200nm wird eine zweite leitende Schicht erzeugt. Mit Hilfe einer streifenförmigen Photolackmaske, deren Streifen parallel zur y-Achse y verlaufen, wird AlSiCu mit zum Beispiel BCl₃ + Cl₂ + CH₄ geätzt, wodurch aus der zweiten leitenden Schicht Bitleitungen B erzeugt werden. Die Bitleitungen B weisen eine Breite von ca. 250nm auf, und Abstände zwischen zueinander benachbarten Bitleitungen B betragen ca. 250nm (siehe Figur 3a und 3b). Die ersten Source/Drain-Gebiete S/D1 wirken als erste Kondensatorelektroden von Speicherkondensatoren. Oberhalb der ersten Source/Drain-Gebiete S/D1 angeordnete Teile der Bitleitungen B wirken als zweite Kondensatorelektroden der Speicherkondensatoren.

Die Vorsprünge V sind in Reihen und Spalten angeordnet. Die x-Achse x zeigt in Reihen-Richtung und die y-Achse y in Spalten-Richtung. Zueinander benachbarte Reihen der Vorsprünge V sind bezüglich der y-Achse y zueinander translationssymmetrisch. Zueinander benachbarte Spalten der Vorsprünge V sind bezüglich der x-Achse x zueinander translationssymmetrisch.

Es sind viele Variationen des Ausführungsbeispiels denkbar, die ebenfalls im Rahmen der Erfindung liegen. Insbesondere können die Abmessungen der beschriebenen Schichten, Vorsprünge, Masken, Spacer und Bitleitungen nach Belieben an die jeweiligen Erfordernisse angepaßt werden. Dasselbe gilt auch für die vorgeschlagenen Dotierstoffkonzentrationen.

Für das Kondensatordielektrikum können auch andere Materialien verwendet werden. Beispielsweise kann eine zum Beispiel 10nm dicke ONO-Schicht erzeugt werden, indem durch thermische Oxidation eine SiO₂-Schicht erzeugt wird und darüber Siliziumnitrid abgeschieden wird, das zum Teil durch thermische Oxidation aufoxidiert wird. Für die Bitleitung kann anderes leitendes Material, wie zum Beispiel in situ dotiertes Polysilizium verwendet werden.

Die Leitfähigkeitstypen der dotierten Schichten können vertauscht werden. Das Substrat kann n-dotiert sein.

## Patentansprüche

1. DRAM-Zellenanordnung,
- bei der ein Halbleitersubstrat (1) in Reihen und Spalten angeordnete Vorsprünge (V) aufweist, wobei zueinander benachbarte Reihen der Vorsprünge (V) bezüglich einer parallel zu den Spalten verlaufenden y-Achse (y) zueinander translationssymmetrisch sind,
- bei der in jedem Vorsprung (V) mindestens ein erstes Source/Drain-Gebiet (S/D1) und ein darunter angeordnetes Kanalgebiet (Ka) eines Auswahltransistors angeordnet sind,
- bei der der Vorsprung (V) mindestens im Bereich des Kanalgebiets (Ka) mit einem Gatedielektrikum (Gd) versehen ist,
- bei der der mit dem Gatedielektrikum (Gd) versehene Vorsprung (V) von einer Gateelektrode (Ga) des Auswahltransistors ringförmig umgeben ist,
- bei der die entlang einer zu den Reihen parallel verlaufende x-Achse (x) benachbarten Gateelektroden (Ga) von Auswahltransistoren aneinander angrenzen und eine Wortleitung bilden,
- bei der zweite Source/Drain-Gebiete (S/D2) der Auswahltransistoren im Halbleitersubstrat (1) vergraben sind,
- bei der das erste Source/Drain-Gebiet (S/D1) mit einer ersten Kondensatorelektrode eines Speicherkondensators elektrisch verbunden ist,
- bei der eine zweite Kondensatorelektrode des Speicherkondensators durch ein Kondensatordielektrikum (Kd) von der ersten Kondensatorelektrode getrennt ist, über der ersten Kondensatorelektrode angeordnet ist und mit einer im wesentlichen parallel zur y-Achse (y) verlaufenden Bitleitung (B) elektrisch verbunden ist.

2. DRAM-Zellenanordnung nach Anspruch 1,
- bei der alle Flanken des Vorsprungs (V) eine gleiche zur x-Achse (x) und zur y-Achse (y) senkrechte Länge aufweisen.

3. DRAM-Zellenanordnung nach einem der Ansprüche 1 bis 2,
- bei der zur x-Achse (x) parallele Abstände zwischen entlang den Reihen angeordneten Versprüngen (V) kleiner sind als zur y-Achse (y) parallele Abstände zwischen entlang den Spalten angeordneten Vorsprüngen (V).

4. DRAM-Zellenanordnung nach einem der Ansprüche 1 bis 3,
- bei der das erste Source/Drain-Gebiet (S/D1) mit der ersten Kondensatorelektrode übereinstimmt.

5. DRAM-Zellenanordnung nach einem der Ansprüche 1 bis 4,
- bei der die zweite Kondensatorelektrode Teil der Bitleitung (B) ist.

6. Verfahren zur Herstellung einer DRAM-Zellenanordnung,
- bei dem in einem Halbleitersubstrat (1) in Reihen und Spalten angeordnete Vorsprünge (V) erzeugt werden, wobei zueinander benachbarte Reihen der Vorsprünge (V) bezüglich einer parallel zu den Spalten verlaufenden y-Achse (y) zueinander translationssymmetrisch sind,
- bei dem als Teile eines der Vorsprünge (V) mindestens ein erstes Source/Drain-Gebiet (S/D1) und ein darunter angeordnetes Kanalgebiet (Ka) eines vertikalen Auswahltransistors erzeugt werden,
- bei dem der Vorsprung (V) mindestens im Bereich des Kanalgebiets (Ka) mit einem Gatedielektrikum (Gd) versehen wird,
- bei dem eine Gateelektrode (Ga) des Auswahltransistors erzeugt wird, die den Vorsprung (V) ringförmig umgibt,
- bei dem eine Wortleitung in Form von entlang einer zu den Reihen parallele x-Achse (x) benachbarte aneinandergrenzende Gateelektroden (Ga) von Auswahltransistoren erzeugt wird,
- bei dem zweite Source/Drain-Gebiete (S/D2) der Auswahltransistoren im Halbleitersubstrat (1) vergraben erzeugt werden,
- bei dem das erste Source/Drain-Gebiet (S/D1) und eine erste Kondensatorelektrode eines Speicherkondensators so erzeugt werden, daß sie miteinander elektrisch verbunden sind,
- bei dem auf der ersten Kondensatorelektrode ein Kondensatordielektrikum (Kd) erzeugt wird,
- bei dem auf dem Kondensatordielektrikum (Kd) eine zweite Kondensatorelektrode des Speicherkondensators und eine damit elektrisch verbundene, im wesentlichen parallel zu den Reihen verlaufende Bitleitung (B) erzeugt werden.

7. Verfahren nach Anspruch 6,
- bei dem die Vorsprünge (V) durch Ätzen mit nur einer Maske (M1) erzeugt werden.

8. Verfahren nach einem der Ansprüche 6 oder 7,
- bei dem die Vorsprünge (V) so erzeugt werden, daß zur x-Achse (x) parallele Abstände zwischen entlang den Reihen angeordneten Versprüngen (V) kleiner sind als zur y-Achse (y) parallele Abstände zwischen entlang den Spalten angeordneten Vorsprüngen (V),
- bei dem die Gateelektroden (Ga) erzeugt werden, indem
a) leitendes Material in einer solchen Dicke im wesentlichen konform abgeschieden wird, daß Räume zwischen den entlang den Reihen angeordneten Vorsprüngen (V) mit dem leitenden Material gefüllt werden aber Räume zwischen den entlang den Spalten angeordneten Vorsprüngen (V) nur teilweise gefüllt werden,
b) das leitende Material anisotrop rückgeätzt wird, bis über dem ersten Source/Drain-Gebiet (S/D1) und zwischen entlang der Spalten benachbarten Vorsprüngen (V) liegende Teile der leitenden Schicht entfernt werden.

9. Verfahren nach Anspruch 8,
- bei dem erste Teile (M1a) der Maske (M1) erzeugt werden, indem Material abgeschieden und durch eine streifenförmige erste Photolackmaske (P1) strukturiert wird, deren Streifen parallel zur y-Achse (y) verlaufen,
- bei dem weiteres Material abgeschieden und rückgeätzt wird, bis an Flanken der ersten Teile (M1a) der Maske (M1) spacerförmige zweite Teile (M1b) der Maske (M1) entstehen,
- bei dem mit Hilfe einer streifenförmigen zweiten Photolackmaske (P2), deren Streifen parallel zur x-Achse (x) verlaufen und deren Abstände voneinander gleich den Abständen der Streifen der ersten Photolackmaske (P1) voneinander sind, die ersten Teile (M1a) und die zweiten Teile (M1b) der Maske (M1) strukturiert werden, wodurch die Maske (M1) entsteht,
- bei dem die Vorsprünge (V) mit Hilfe der Maske (M1) erzeugt werden.

10. Verfahren nach einem der Ansprüche 6 bis 9,
- bei dem in oder auf dem Halbleitersubstrat (1) eine von einem ersten Leitfähigkeitstyp dotierte erste Schicht (S1), darüber eine, von einem zweiten, zum ersten Leitfähigkeitstyp entgegengesetzten Leitfähigkeitstyp dotierte zweite Schicht (S2) und darüber eine vom ersten Leitfähigkeitstyp dotierte dritte Schicht (S3) erzeugt werden,
- bei dem die Vorsprünge (V) so erzeugt werden, daß dabei die dritte Schicht (S3) und die zweite Schicht (S2) durchtrennt werden.

11. Verfahren nach einem der Ansprüche 6 bis 10,
- bei dem nach Erzeugung der Gateelektroden (Ga) eine isolierende Struktur (I) erzeugt wird, indem isolierendes Material abgeschieden und planarisiert wird, bis die ersten Source/Drain-Gebiete (S/D1) freigelegt werden,
- bei dem ein Kondensatordielektrikum (Kd) abgeschieden wird,
- bei dem eine zweite leitende Schicht erzeugt wird, und streifenförmig strukturiert wird, so daß parallel zur y-Achse (y) verlaufende Bitleitungen (B) entstehen, die die ersten Source/Drain-Gebiete (S/D1) bedecken und die oberhalb der ersten Source/Drain-Gebiete (S/D1) als zweite Kondensatorelektroden wirken.
